# EUROPEAN PATENT APPLICATION

(11) **EP 0 677 873 A1**
(43) Date of publication of application: **18.10.1995**
(21) Application number: 95302238.1
(22) Date of filing: 04.04.1995
(51) Int. Cl.: H01L 23/495

(54) **A lead frame and a process for fabricating a packaged device containing the lead frame**

(30) Priority: 13.04.1994 US 226905
(71) Applicant: AT&T Corp., New York, NY 10013-2412 (US)
(72) Inventor: Manzione, Louis Thomas, Summit, New Jersey 07901 (US); Weld, John David, Succasunna, New Jersey 07876 (US); Richman, Russell Mark, Schnecksville, Pennsylvania 18078 (US)
(74) Representative: Johnston, Kenneth Graham

(57) **Abstract**

A lead frame (110) with a plurality of device supports (120) is disclosed. The lead frame defines a cavity. The plurality of supports (120) extend from the lead frame (110) into the cavity defined by the lead frame (110). The supports (120) do not contact each other within the confines of the cavity. The supports (120) are not attached to the perimeter of the lead frame cavity at more than two points. A device (100) is affixed to the supports (120) and wire bonded (145) to the wire leads (140) of the lead frame (110) using conventional techniques. The plurality of device supports (120), because of their orientation and their small size relative to the size of the devices (100) which are mounted thereon, offer processing advantages that provide a better protected, packaged device and, if desired, the capability of producing smaller packaged devices.

## Description

### Technical Field

The invention is directed to a lead frame and a process for packaging a device into a package with the lead frame. The invention is also directed to packaged devices.

### Art Background

Devices such as diodes and integrated circuits are components which are incorporated into larger systems. Since the systems cannot perform their intended functions unless the devices incorporated therein are functioning properly, it is important that the devices be protected from conditions which could damage them or otherwise adversely affect their performance. The devices are therefore typically packaged after they are fabricated to protect them before, while, and after they are incorporated into these larger systems. The package is a protective material, typically a plastic or ceramic material, surrounding the device. The package shields the device therein from contact with other devices during handling, and protects the device from the surrounding environment.

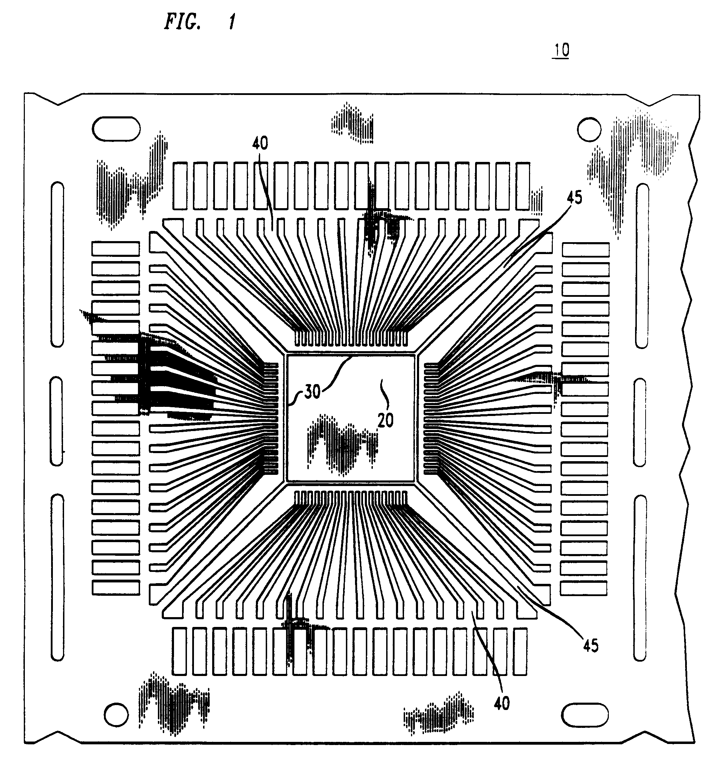

Prior to packaging, the device is provided with electrical leads that permit the device to be electrically connected to the system, or other subassemblies within the larger system. One way in which a device is equipped with electrical leads is by affixing the device to a lead frame. A lead frame is a supporting structure containing a mounting pad for the device and a pattern of fingers or leads that is formed by etching or stamping a sheet of metal (typically copper or iron-nickel alloy). An example of a lead frame 10 is depicted in FIG. 1. The device 20, an integrated circuit, is affixed to the lead frame 10 by placing the integrated circuit 20 on a support such as the mounting pad 30 with a suitable adhesive. The integrated circuit is then electrically connected to the lead frame 10 by a technique such as wire bonding, in which the integrated circuit contacts (not shown) are connected to the lead frame fingers or leads 40 with thin wires of gold or aluminum. The mounting pad 30 supports the integrated circuit during the packaging process. All connections 45 from the lead frame 10 to the mounting pad 30 are severed after packaging.

A common way to package the device is to encapsulate it in plastic using a molding process. To mold the package, the lead frame 10 with the integrated circuit 20 mounted thereon is placed in a mold. The lead frame leads 40 extend from the mold. A molding compound is then transferred into the mold and the device is encapsulated in the molding compound. The supporting frame of the lead frame is trimmed from the package by severing the connections 45, thereby electrically isolating the leads projecting from the package. The resulting package is an integrated circuit encapsulated in a molding compound with numerous leads projecting from the package. The leads are then electrically connected to external circuitry to incorporate the integrated circuit into a larger system.

Systems, such as consumer electronics, into which integrated circuits are frequently incorporated, are getting smaller. The size of the packages in which these integrated circuits are placed is also being reduced so that they will take up less space in these smaller systems. Decreasing the package size presents several processing difficulties, however. First, the thickness of the molding compound above and below the device is frequently equalized to avoid subjecting the device to stresses caused by the different coefficients of thermal expansion of the device, the lead frame, and the molding compound. This requires the device to be centered in the mold cavity as the package is formed. Typically, the lead frame is centered in the mold cavity because the lead frame leads protrude from the mold cavity at the union of the top and bottom halves of the mold cavity. Clearly, a device that rests entirely on one side of the lead frame will be off-center in a mold cavity in which the lead frame is centered. Therefore, the lead frame configuration depicted in FIG. 1 impedes centering the device in the mold cavity and, ultimately, the package. Although the connections 45 in the lead frame 10 are bent downward at times, the problems enumerated herein that are associated with this lead frame configuration are not entirely avoided.

Placing the device in the center of the package is further complicated by the process in which the device is wire bonded to the lead frame. After the device is affixed to the lead frame mounting pad, the leads of the lead frame are wire bonded to the bonding pads on the device. Because of the way in which the wire bonding process is automated, some slack must be provided in the wires. This slack, typically referred to as wire loop, causes the wires to extend about 100 to 200 microns above the device. The wire loops are also encapsulated in molding compound during device packaging. Therefore, the package must be sufficiently thick to accommodate the wires. As the need for thinner packages increases, it is necessary to reduce the thickness of other components in the package in order to package the wire loops and achieve the objective of a thinner package with the device substantially centered therein.

Also, as the thickness of the package decreases, there are greater impediments to the uniform distribution of the molding compound around the device during the packaging process if the device and the associated lead frame mounting pad are not approximately centered in the mold cavity. If the device is positioned in the mold cavity such that it is substantially closer to the mold cavity wall at some points than it is at others, flow paths of unequal size will be formed. For example, if the device is substantially closer to the top wall of the molding cavity than the bottom cavity wall, the flow of the molding compound in the molding cavity will be uneven. If there is a substantial difference in the size of these flow paths, an uneven distribution of the molding compound in the mold will result. This uneven distribution causes additional stress on the device in the package, and may also cause cracks, fissures, and gaps in the package itself, making the device more susceptible to damage. A lead frame and a process for packaging a device that avoids these problems, yet can be adapted to current process technology, is therefore desired.

### Summary of the Invention

A lead frame that has a plurality of small supports for a device instead of one relatively large mounting pad is disclosed. The supports extend into a cavity provided in a lead frame. Each support connects to the lead frame at no more than two points on the perimeter of the lead frame cavity and the supports are non-continuous in the lead frame cavity. The supports are configured such that the lead frame and a portion of the device resting on the supports are in the same plane. It is advantageous if the supports are forged or otherwise reduced in thickness before the device is placed thereon. The thickness of the supports is about eighty percent of the thickness of the lead frame. Certain advantages are provided if the thickness of the supports is reduced to about twenty percent of the thickness of the lead frame.

The device is affixed to the supports and wire bonded to the lead frame using conventional technology. Each of the supports has a surface area that is substantially smaller than the device it supports. The supports also have substantially less surface area than a single mounting pad of a conventional design. Thermomechanical stresses caused by heating or cooling of the package are reduced in such a package because the surface area of the supports is substantially less than the surface area of the single mounting pad. Such thermomechanical stresses result because the coefficient of thermal expansion of the frame is significantly different than the coefficient of thermal expansion of the chip.

When a package is formed around the device that is mounted on the lead frame, the supports do not significantly interfere with the uniform flow of molding compound around the device and thus the difficulties associated with non-uniform flow of molding compound around the device are avoided. By providing fewer impediments than a single mounting pad to the even distribution of the molding compound around the device, the supports also prevent excessive thermomechanical stress on the device that would be caused by the expansion or contraction of unequal thicknesses of molding compound around the device.

The present invention is also embodied by a packaged device. A device such as a diode or an integrated circuit is packaged with a lead frame as previously described. It is advantageous if the thickness of the package is about 0.6 mm or less.

### Brief Description of the Drawings

FIG. 1 is an illustration of a lead frame;
FIG. 2 is an illustration of a lead frame that is an embodiment of the present invention; and
FIG. 3 is a cut-away side view along line 3-3 of the lead frame depicted in FIG. 2 of a package that is an embodiment of the present invention;
FIG. 4 is a cut-away side view along line 3-3 of the lead frame depicted in FIG. 2 in the mold prior to introducing molding compound into the mold cavity.
FIG. 5 is an illustration of a lead frame that is an alternate embodiment of the present invention; and
FIG. 6 is an illustration of a lead frame that is an alternate embodiment of the present invention.

### Detailed Description

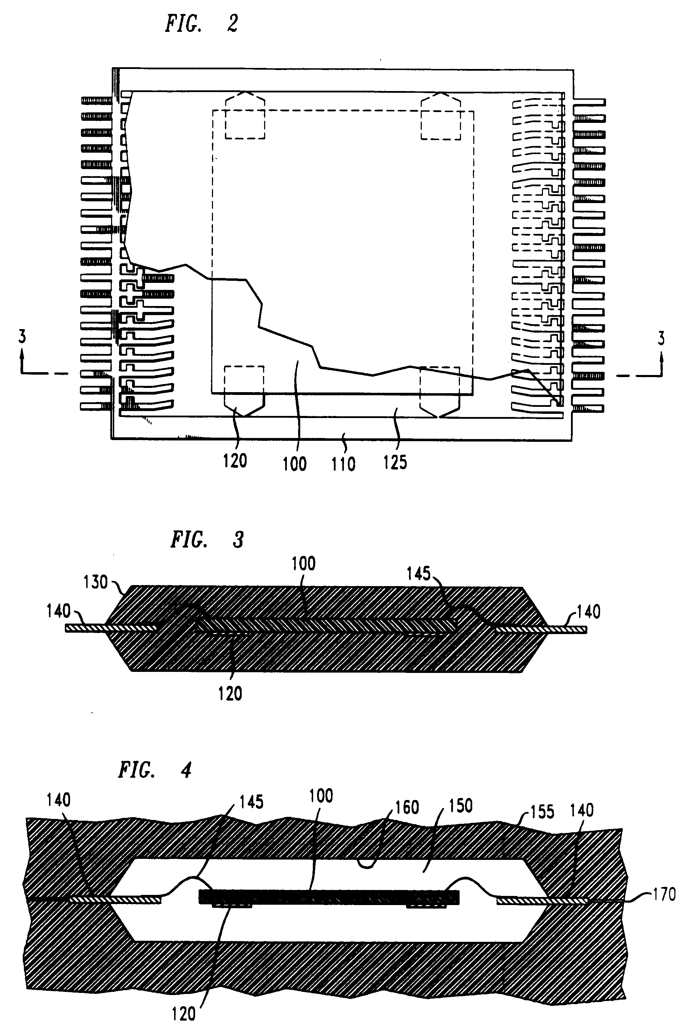

Referring to FIG. 2, a depicted device, an integrated circuit 100, is placed on a lead frame 110. The lead frame defines a cavity 125. The lead frame is equipped with a plurality of supports 120. These supports 120 project from the lead frame 110 into the cavity 125. The supports 120 are non-continuous in the lead frame cavity. Non-continuous, in this context, means that, within the boundary of the cavity defined by the lead frame, the individual supports 120 are not attached to the lead frame at more than two points on the perimeter of the lead frame cavity and the supports are not attached to each other within the cavity.

The integrated circuit 100 is positioned on the lead frame such that it is supported by the supports 120. The surface area of the supports 120 is substantially less than the surface area of the integrated circuit 100. The integrated circuit 100 is affixed to the supports 120 by means such as a die attach adhesive. Such adhesives are known to those skilled in the art.

The lead frame 110 itself is made of conventional metals using conventional processing techniques such as stamping or etching. The lead frames are constructed of materials such as an iron-nickel alloy (60/40), also known as alloy 42, and copper-rich alloys, an example of which is alloy 7025. One skilled in the art will appreciate that there are many metals from which lead frames are made. If the package is to have a thickness of 0.6 mm or less, it is advantageous if the lead frame has a thickness of 150 microns or less.

Referring to FIG. 3, the integrated circuit 100 is encapsulated by a molding compound 130. Typical molding compounds include plastic materials. Suitable molding compounds are known to those skilled in the art. The molding compound 130 is transferred in flowable form into a mold cavity containing the device 100 mounted on the lead frame 120. For thin packages, i.e., packages with a thickness of about 0.6 mm or less, it is advantageous if the viscosity of the molding compound 130, which depends on many different molding parameters including temperature, shear rate, and degree of polymerization, is about 300 poise or less. It is, however, contemplated that higher viscosity molding compounds are also suitable, especially when fabricating thicker packages, because the lead frame is configured to facilitate the uniform distribution of molding compound around the integrated circuit.

An example of a suitable molding compound is one that contains a biphenyl epoxy base resin and extra fine spherical filler particles with many different size distributions. Examples of suitable molding compounds include Sumitomo Bakelite EME-7320C, which is obtained commercially from Sumitomo, Bakelite Co., Ltd., and MP-7150 Imp1, which is obtained commercially from Nitto Denko America, Inc.

The lead frame 110 is configured to facilitate the flow of molding compound around the lead frame during the packaging process. It is therefore advantageous if the individual supports 120 do not contact each other within the cavity defined by the lead frame. Also, the individual supports are configured such that they will not significantly impede the flow of molding compound around or between them. In this regard, it is advantageous if the supports do not span more than two sides of the cavity. Span, in this context, means that the individual supports are fixed to the lead frame at two points on the perimeter of the lead frame cavity. Preferably, the supports are affixed to the lead frame at only one point on the perimeter of the cavity.

In this regard, it is also advantageous if the supports 120 are thinner than the thickness of the lead frame leads 140 as depicted in FIG. 3. The supports 120 are reduced in thickness prior to the integrated circuit 100 being placed on them. Because the support thickness is less than the lead frame thickness, a portion of the integrated circuit 100 resting on the supports 120 is in the same plane as the lead frame 110. The supports 120 are forged by placing them in a conventional forging apparatus such as a die press and compressing them. Forging the supports reduces their thickness substantially.

### Example 1: A Method for Reducing the Lead Frame Support Thickness

For example, a 5 mil-thick, 8-site lead frame was stamped using conventional techniques. The lead frame had four 30 mil-by-80 mil tabs per site. The tabs were forged to a thickness of about 1 to about 1.5 mils. Thus, the thickness of the support tabs was reduced to about twenty to thirty percent of the lead frame thickness. The lead frames were made of both copper alloy 7025 and iron-nickel alloy 42. A single-die operation was used to forge all support tabs (since the lead frame was an 8-site lead frame with four tabs per site, 32 tabs were forged simultaneously) on the lead frame. The lead frame was lubricated with a light oil before being forged in a 9 ton press.

Although it is advantageous if the thickness of the tabs is reduced by forging as described above, it is contemplated that the thickness of the tabs is also reduced by other means such as etching. The invention is not to be construed as limited to a lead frame in which the support thickness was reduced by a particular means.

A substantial reduction in thickness in this context is a reduction of at least twenty percent relative to the thickness of the lead frame. Therefore, the thickness of the supports is about eighty percent or less of the lead frame thickness. It is contemplated that the thickness of the supports will be reduced to about fifty percent of the lead frame thickness. It is advantageous if the thickness of the supports is reduced to about twenty percent or less than the thickness of the lead frame itself. For example, if the supports of a 125 micron-thick lead frame are forged in the previously described manner, the supports will have a resulting thickness of about 100 microns or less. Supports of this thickness can adequately support the device during assembly, wire bonding and molding.

The integrated circuit is connected to the lead frame leads via wire bonds 145. As illustrated in FIG. 3, the wire bonds have a loop height over the integrated circuit 100. This loop height is typically about 100 microns to about 200 microns. Conventional processing techniques are used to attach the wire bonds 145 to the integrated circuit 100 and the lead frame leads 140. To maintain this loop height, it is advantageous, but not required, that the supports 120 will be downset, i.e., lowered relative to the lead frame, before the integrated circuit is placed thereon.

As illustrated in FIG. 4, the package is formed by placing the lead frame 110, its leads 140, and the integrated circuit 100 affixed thereto in a mold cavity 150 defined by a mold 155. The dimensions of the mold cavity 150 are tailored to the desired thickness of the package. However, since compact components are desired, it is advantageous to select the dimensions of the cavity so that there is minimum clearance between the integrated circuit 100 and the interior walls 160 of the mold cavity. Consequently, the configuration of the supports 120 is selected so that it will not obstruct the flow of the molding compound (not shown) between the integrated circuit 100 and the cavity wall 160. The orientation of the supports 120 is selected to be compatible with the direction in which the molding compound will flow in the cavity. For example, if the molding compound flows into the cavity through gate 170 in the cavity wall 160, the supports will be positioned so that flow in the direction perpendicular to the cavity wall 160 will not be substantially obstructed.

The lead frame is also configured so that the support tabs are capable of being electrically isolated from the rest of the lead frame once the package is formed. For example, as depicted in FIG. 2, the supports 120 are affixed to the lead frame at a point that remains outside the package. The support tabs 120 are severed from the lead frame 110 after the package is formed. The support tabs are severed from the lead frame using conventional techniques.

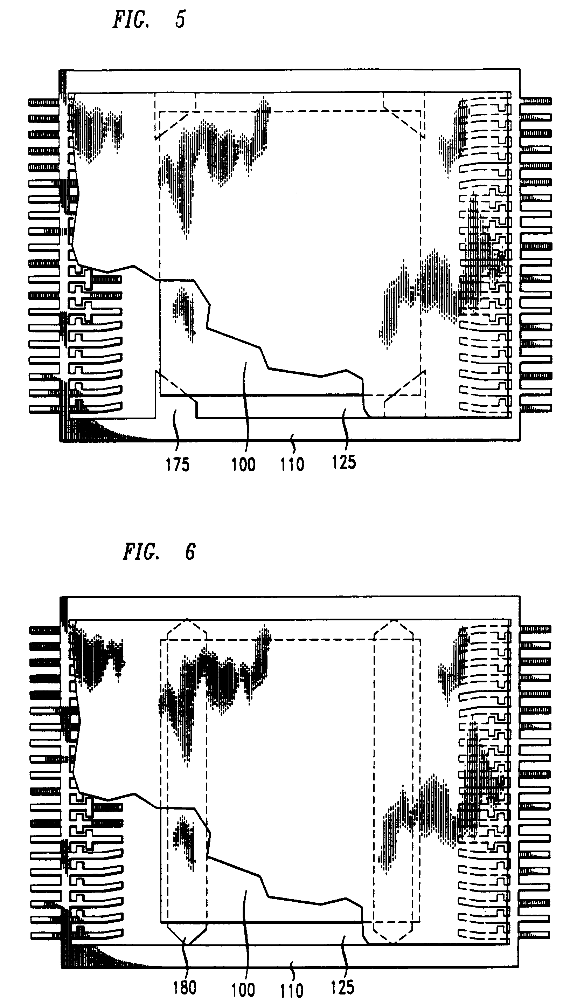

Although a lead frame with four small tabs 120 is depicted in FIG. 2, one skilled in the art will appreciate that other configurations will be acceptable. For example, four supports 175, in the corners of the cavity cut out 125 in the lead frame 110, are contemplated as useful for mounting the device. Such a configuration is illustrated in FIG. 5. Multiple thin strips 180 which bridge two opposing sides of the cavity cut out 125 in the lead frame 110 are also contemplated as useful. Such a configuration is illustrated in FIG. 6. It is contemplated that, if such a support configuration is used, however, that the molding compound will flow into the cavity in a direction substantially parallel to the length of the supports 180. If this relationship between the support configuration illustrated in FIG. 6 and the molding compound flow direction is maintained, the configuration should not affect the flow of molding compound in a manner that is adverse to the objectives of the lead frame configuration of the present invention.

As stated previously, one skilled in the art will appreciate that the orientation of the supports is selected to be compatible with the direction in which the molding compound flows in the mold cavity. One skilled in the art will also appreciate that if ratio of the surface area of the supports 120 to the area of the integrated circuit surface supported by the supports is less than one, the flow of the molding compound around the integrated circuit during the molding process will be less restricted than if the ratio is one-to-one or larger. Such a ratio is difficult to quantify, because it may vary widely from embodiment to embodiment. However, a ratio of less than 0.5 is contemplated. A ratio of less than 0.2 is advantageous. The supports should not be so small, however, that they are unable to perform their support function.

## Claims

1. A packaged device comprising:
a lead frame with a cavity and a plurality of supports projecting from the lead frame into the cavity wherein each individual support is non-continuous with the other supports within the cavity and wherein each individual support is not attached to the lead frame at more than two points on the perimeter of the lead frame cavity;
a device affixed to the support tabs; and
a molding compound substantially surrounding the integrated circuit.

2. The packaged device of claim 1 wherein the lead frame forms a perimeter around the cavity and the supports are not connected within the perimeter formed by the lead frame.

3. The packaged device of claim 1 wherein the device is an integrated circuit.

4. The packaged device of claim 1 wherein the thickness of the supports is eighty percent or less of the thickness of the lead frame at least a portion of the device is in a plane defined by the lead frame.

5. A packaged device comprising a lead frame with a cavity and a plurality of device supports projecting into the cavity wherein the individual supports are non-continuous with each other in the cavity; a device affixed to the plurality of supports and a molding compound substantially surrounding the device, wherein the surface area of the supports is less than the area of surface of the device to which the tabs are affixed and wherein at least a portion of the device is in a plane defined by the lead frame.

6. A process for packaging a device comprising:
reducing the thickness of a plurality of supports attached to a lead frame to less than the thickness of the lead frame wherein the supports project into a cavity of the lead frame; affixing a device to the plurality of supports; and
encapsulating the device with a molding compound.

7. The process of claim 6 wherein the thickness of the supports is reduced by forging.

8. The process of claim 7 wherein the thickness of the supports is reduced to about 80 percent or less of the thickness of the lead frame.

9. The process of claim 7 wherein the thickness of the supports is reduced to about 20 percent of the thickness of the lead frame.

10. A lead frame comprising:
a conductive metal material configured to contain a frame with a plurality of leads;
a cavity defined by the frame; and
a plurality of device supports extending from the frame into the cavity defined by the frame wherein each individual device support is non-continuous with the other supports in the cavity.

11. The lead frame of claim 10 wherein the support thickness is about 80 percent or less of the lead frame thickness.

12. The lead frame of claim 10 wherein the support thickness is about 20 percent or less of the lead frame thickness.
